# EUROPÄISCHE PATENTSCHRIFT

(11) **EP 2 841 529 B1**
(45) Veröffentlichungstag und Bekanntmachung des Hinweises auf die Patenterteilung: **20.07.2016**
(21) Anmeldenummer: 13711576.2
(22) Anmeldetag: 22.03.2013
(51) Int. Cl.: C09K 11/67, H01L 33/50

(54) **SILICAT-LEUCHTSTOFFE**
SILICATE PHOSPHORS
LUMINOPHORES À BASE DE SILICATE

(30) Priorität: 24.04.2012 EP 12002867
(43) Veröffentlichungstag der Anmeldung: 04.03.2015
(73) Patentinhaber: Merck Patent GmbH, 64293 Darmstadt (DE)
(72) Erfinder: WINKLER, Holger, 64291 Darmstadt (DE); JUESTEL, Thomas, 58455 Witten (DE); KATELNIKOVAS, Arturas, Vilnius, LT-03225 (LT); BAUR, Florian, 48165 Muenster (DE)
(86) Internationale Anmeldenummer: PCT/EP2013/000872
(87) Internationale Veröffentlichungsnummer: WO 2013/159857

(56) Entgegenhaltungen:
- US-A- 3 718 600
- US-A1- 2010 224 828
- DE-YIN WANG ET AL: "Synthesis, crystal structure, and photoluminescence of a novel blue-green emitting phosphor: BaHfSi3O9:Eu2+", JOURNAL OF MATERIALS CHEMISTRY, Bd. 21, Nr. 45, 19. Oktober 2011 (2011-10-19), Seite 18261, XP055068865, ISSN: 0959-9428, DOI: 10.1039/c1jm13438h
- DE-YIN WANG ET AL: "BaZrSi3O9:Eu2+: a cyan-emitting phosphor with high quantum efficiency for white light-emitting diodes", JOURNAL OF MATERIALS CHEMISTRY, Bd. 21, Nr. 29, 9. Juni 2011 (2011-06-09), Seite 10818, XP055068866, ISSN: 0959-9428, DOI: 10.1039/c1jm00080b

## Beschreibung

Die vorliegende Erfindung betrifft Eu-, Sm- oder Pr-dotierte Silicat-Verbindungen, ein Verfahren zur deren Herstellung sowie deren Verwendung als Konversionsleuchtstoffe. Die vorliegende Erfindung betrifft zudem ein Emissions-konvertierendes Material umfassend mindestens den erfindungsgemäßen Konversionsleuchtstoff sowie dessen Verwendung in Lichtquellen, insbesondere pc-LEDs (phosphor converted light emitting devices). Weitere Gegenstände der vorliegenden Erfindung sind Lichtquellen, insbesondere pc-LEDs, und Beleuchtungseinheiten, die eine Primärlichtquelle und das erfindungsgemäße Emissions-konvertierende Material enthalten.

Seit mehr als 100 Jahren werden anorganische Leuchtstoffe entwickelt, um emissive Bildschirme, Röntgenverstärker und Strahlungs- bzw. Lichtquellen spektral so anzupassen, dass sie die Anforderungen des jeweiligen Anwendungsgebietes möglichst optimal erfüllen und gleichzeitig möglichst wenig Energie verbrauchen. Dabei ist die Art der Anregung, d. h. die Natur der primären Strahlungsquelle und das erforderliche Emissionsspektrum von entscheidender Bedeutung für die Auswahl der Wirtsgitter und der Aktivatoren.

Insbesondere für Fluoreszenzlichtquellen für die Allgemeinbeleuchtung, also für Niederdruckentladungslampen und Leuchtdioden, werden ständig neue Leuchtstoffe entwickelt, um die Energieeffizienz, Farbwiedergabe und Stabilität weiter zu erhöhen.

Um durch die additive Farbmischung weiß emittierende anorganische LEDs (light emitting diodes) zu erhalten, gibt es prinzipiell drei verschiedene Ansätze:
(1) Die RGB LEDs (rot + grün + blau LEDs), bei denen weißes Licht durch Mischung des Lichtes drei verschiedener im roten, grünen und blauen Spektralbereich emittierender Leuchtdioden erzeugt wird.
(2) Die Systeme UV LED + RGB Leuchtstoff, bei denen ein im UV-Bereich emittierender Halbleiter (Primärlichtquelle) das Licht an die Umgebung abgibt, in der drei verschiedene Leuchtstoffe (Konversionsleuchtstoffe) angeregt werden, die im roten, grünen und blauen Spektralbereich emittieren.
(3) Komplementäre Systeme, bei denen ein emittierender Halbleiter (Primärlichtquelle) beispielsweise blaues Licht abgibt, das einen oder mehrere Leuchtstoffe (Konversionsleuchtstoff) anregt, die beispielsweise im gelben Bereich Licht emittieren. Durch Mischung des blauen und des gelben Lichts entsteht dann weißes Licht. Alternativ kann eine Leuchtstoffmischung verwendet werden, die grünes und rotes Licht emittiert.

Binär-komplementäre Systeme haben den Vorteil, dass sie mit nur einer Primärlichtquelle und - im einfachsten Fall - mit nur einem Konversionsleuchtstoff in der Lage sind, weißes Licht zu produzieren. Das Bekannteste dieser Systeme besteht aus einem Indium-Aluminium-Nitrid-Chip als Primärlichtquelle, der Licht im blauen Spektralbereich abgibt, und einem Cer-dotierten Yttrium-Aluminium-Granat (YAG:Ce) als Konversionsleuchtstoff, der im blauen Bereich angeregt wird und Licht im gelben Spektralbereich abgibt. Verbesserungen des Farbwiedergabe-Indexes sowie der Stabilität der Farbtemperatur sind jedoch wünschenswert.

Die binär-komplementären Systeme benötigen also bei Verwendung eines blau emittierenden Halbleiters als Primärlichtquelle einen gelben Konversionsleuchtstoff oder grün und rot emittierende Konversionsleuchtstoffe, um weißes Licht wiederzugeben. Verwendet man alternativ dazu als Primärlichtquelle einen im violetten Spektralbereich oder im nahen UV-Spektrum emittierenden Halbleiter, so muss entweder eine RGB-Leuchtstoffmischung oder eine dichromatische Mischung von zwei komplementäres Licht emittierenden Konversionsleuchtstoffen verwendet werden, um weißes Licht zu erhalten. Bei der Verwendung eines Systems mit einer Primärlichtquelle im violetten oder UV-Bereich und von zwei komplementären Konversionsleuchtstoffen können Leuchtdioden mit einem besonders hohen Lumenäquivalent bereitgestellt werden. Ein weiterer Vorteil einer dichromatischen Leuchtstoffmischung ist die geringere spektrale Wechselwirkung und der damit verbundene höhere "Package Gain" ("Packungsdichte").

Deshalb gewinnen heute insbesondere anorganische fluoreszierende Pulver, die im blauen und/oder UV-Bereich des Spektrums angeregt werden können, immer stärker an Bedeutung als Konversionsleuchtstoffe für Lichtquellen, insbesondere für pc-LEDs.

Mittlerweile sind viele Konversionsleuchtstoffe bekannt, beispielsweise Erdalkali-Orthosilicate, Thiogallate, Granate und Nitride, die jeweils mit Ce³⁺ oder Eu²⁺ dotiert sind.

Es besteht jedoch ständig Bedarf an neuen Konversionsleuchtstoffen, die im blauen oder UV-Bereich angeregt werden können und Licht im sichtbaren Bereich des Anregungsspektrums abgeben.

Es war deshalb die Aufgabe der vorliegenden Erfindung, neue Materialien zur Verfügung zu stellen, mit denen Strahlung im blauen oder im UV-Bereich effizient in Strahlung des sichtbaren Spektrums umgewandelt werden kann.

Es ist bekannt, dass hexagonale Festkörperverbindungen der Formel BaZr₁₋ₓHfₓSi₃O₃ (x gleich 0 bis 1) des Mineraltyps Bazirit bei der Photonen-Bestrahlung bei 160 oder 254 nm intensive UV- und blaue Lumineszenz mit einem Emissionsmaximum bei 260 nm bzw. 440 nm zeigt. Es wurde nun von den Erfindern der vorliegenden Anmeldung überraschenderweise festgestellt, dass, wenn ein Teil der Zr- bzw. Hf-Ionen in dem Mineral durch Eu-, Pr- oder Sm-Ionen ersetzt ist, ein cyan-emittierender bzw. rotemittierender Leuchtstoff erhalten werden kann, der mit einer Quantenausbeute von bis zu 90 % emittiert.

Ein erster Gegenstand der vorliegenden Erfindung ist daher eine Verbindung der Formel I

(Ba_{y}Sr_{1-y})Zr₁₋ₓHfₓSi₃O₉ (I),

wobei x im Bereich von 0 bis 1 und unabhängig davon y im Bereich von 0 bis 1 liegt,

dadurch gekennzeichnet, dass ein Teil der Zr- bzw. Hf-Ionen durch dreiwertige Metallionen, die aus der Gruppe bestehend aus Pr³⁺, Sm³⁺, Eu³⁺ und Kombinationen davon ausgewählt sind, ersetzt ist und zum Ladungsausgleich eine zu den Pr³⁺-, Sm³⁺-, Eu³⁺-Ionen äquivalente Menge an Alkalimetallionen vorhanden ist.

Ein solcher Austausch von Ionen wird auch als "Dotieren" bezeichnet. Insofern werden die Eu-, Pr- oder Sm-Ionen in dieser Anmeldung auch als Dotierionen bezeichnet.

Dabei ist es in einer Erfindungsvariante bevorzugt, wenn x gleich 0 oder 1 ist, es sich bei der Verbindung also entweder um (Ba_{y}Sr_{1-y})ZrSi₃O₉ oder (Ba_{y}Sr_{1-y})HfSi₃O₉ handelt. Diese Erfindungsvariante hat den Vorteil einer vereinfachten Herstellung der Materialien, da die Anzahl verschiedener Edukte niedrig gehalten werden kann.

Es ist des Weiteren bevorzugt, dass bei der erfindungsgemäßen Verbindung der Formel I 0,1 bzw. 20 mol%, der Zr- bzw. Hf-Ionen durch Eu-, Pr- oder Sm-Ionen ersetzt ist, stärker bevorzugt 0,2 bis 10 mol% und am stärksten bevorzugt 0,3 bis 5 mol%.

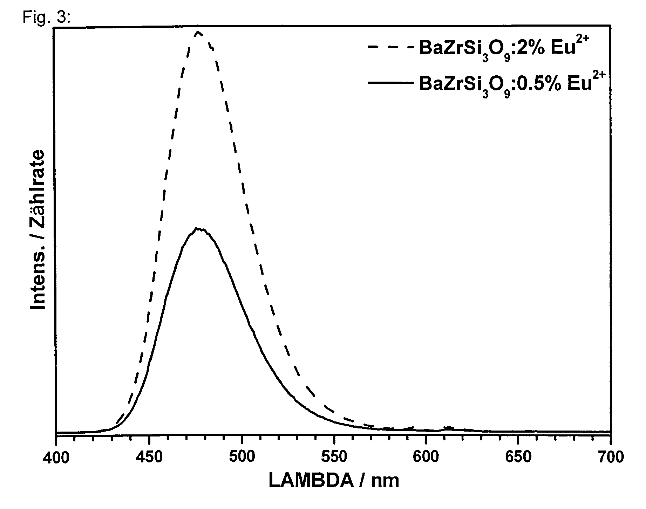

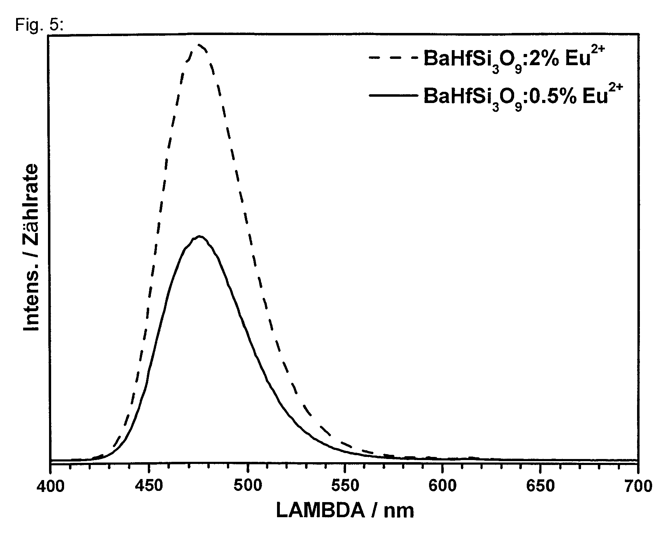

In einer nicht erfindungsgemäßen Ausführungsform (Referenz) liegen die Eu-Ionen in zweiwertiger Form vor, so dass ein vierwertiges Zr- bzw. Hf-Ion durch zwei Eu-Ionen ersetzt ist. In diesem Fall wird ein cyan-emittierender Leuchtstoff mit einer sehr hohen Quantenausbeute von bis zu 90 % bereitgestellt. Die Figuren 3 und 5 zeigen Emissionsspektren für die Verbindungen BaZrSi₃O₉:Eu²⁺ und BaHfSi₃O₉:Eu²⁺ bei unterschiedlichen Dotierungsgehalten. Die Absorption ist bei steigender Dotierung leicht rotverschoben. Auf diese Weise kann je nach Dotierungsgehalt das Absorptionsmaximum entsprechend eingestellt werden. Diese Verbindungen eignen sich besonders zur Anregung im nahen UV-Bereich oder im blauen Bereich.

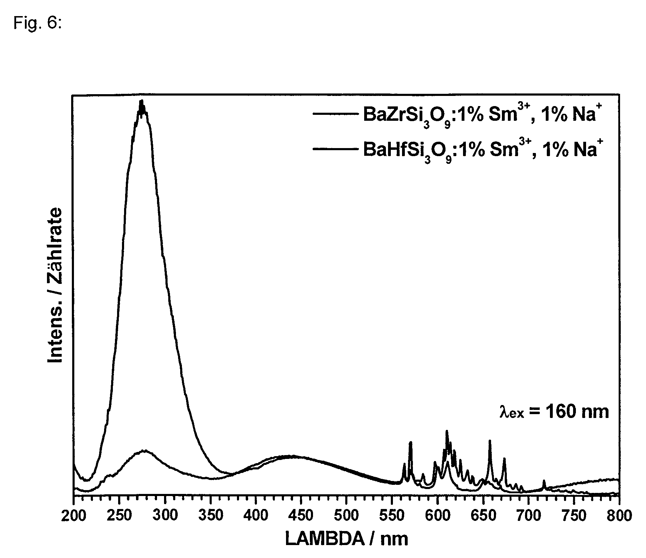

Gemäß der vorliegenden Erfindung sind die vierwertigen Zr- bzw. Hf-Ionen der Verbindung der Formel I durch dreiwertige Metallionen, die aus der Gruppe ausgewählt sind, die aus Pr³⁺, Sm³⁺, Eu³⁺ und Kombinationen davon besteht, ausgetauscht. Da die ausgetauschten Zr- bzw. Hf-Ionen vierwertige Ionen sind, sind in äquimolarer Anzahl zu den dreiwertigen Dotierionen auch einwertige Alkalimetallionen zum Ladungsausgleich vorhanden. Bezüglich der Alkalimetallionen spricht man hier von sogenannten Co-Dotierungen. Mögliche einzusetzende Alkalimetallionen sind Li⁺, Na⁺, K⁺, Rb⁺ oder Cs⁺, worin Na⁺ bevorzugt ist. Die Figuren 6 bis 8 zeigen Reflexionsspektren, Anregungsspektren und Emissionsspektren für die erfindungsgemäßen Verbindungen BaZrSi₃O₉:Sm³⁺/Na⁺, BaHfSi₃O₉:Sm³⁺/Na⁺, BaZrSi₃O₉:Eu³⁺/Na⁺, BaHfSi₃O₉:Eu³⁺/Na⁺, BaZrSi₃O₉:Pr³⁺/Na⁺ und BaHfSi₃O₉:Pr³⁺/Na⁺. Diese erfindungsgemäß ebenfalls bevorzugten Verbindungen eignen sich besonders zur Anregung im UV-Bereich bei 150 - 270 nm.

Im Übrigen kann die Emissionsfarbe der Verbindung nach Formel I auch über den Barium- bzw. Strontiumgehalt beeinflusst werden. So kann ein hoher Bariumgehalt (0,7 < y ≤ 1) oder sogar eine Verbindung, die gar kein Strontium enthält (y = 1) bevorzugt sein, wenn die Emission im cyanfarbenen oder grünen Wellenlängenbereich liegen soll. Umgekehrt kann, wenn eine Emission im orange-roten Bereich gewünscht ist, eine Verbindung mit hohem Strontiumgehalt (0 ≤ y < 0,3) oder sogar eine Barium-freie Verbindung (y = 0) bevorzugt sein.

Ein weiterer Gegenstand der vorliegenden Erfindung ist ein Verfahren zur Herstellung einer Verbindung der Formel I, umfassend die folgenden Verfahrensschritte:
a) Bereitstellen einer Barium- und/oder Strontiumquelle, einer Zirkonium- und/oder Hafniumquelle, einer Siliciumquelle und einer Quelle eines der Metalle Samarium, Praseodym oder Europium;
b) Vermengen der unter Schritt a) bereitgestellten Quellen; und
c) Sintern der unter Schritt b) vermengten Quellen bei einer Temperatur im Bereich von 1000 bis 1700 °C.
dadurch gekennzeichnet, dass in Schritt a) zusätzlich eine anorganische Alkalimetallverbindung bereitgestellt wird und die Temperaturbehandlung in Schritt c) an Luft durchgeführt wird.

Unter einer Barium- oder Strontiumquelle versteht man erfindungsgemäß eine anorganische oder organische Barium- oder Strontiumverbindung, die in der Lage ist, sich beim Kalzinieren in Barium- oder Strontiumoxid umzusetzen. Mögliche Barium- oder Strontiumquellen sind Barium- oder Strontiumcarbonat, Barium- oder Strontiumsulfat, Barium- oder Strontiumnitrat, Barium- oder Strontiumoxalat, Barium- oder Strontiumoxid und Barium- oder Strontiumhalogenid, Barium- oder Strontiumperoxid, worin Barium- oder Strontiumcarbonat besonders bevorzugt ist. Dabei kann es bevorzugt sein, wenn Barium und Strontium in der "Quelle" schon in dem Verhältnis zueinander vorliegen, in dem diese Erdalkaliionen auch in der erfindungsgemäßen Verbindung der Formel I vorliegen sollen.

Unter einer Zirkonium- bzw. Hafniumquelle versteht man erfindungsgemäß eine organische oder anorganische Zirkonium- bzw. Hafniumverbindung, die sich beim Kalzinieren zu einem Oxid zersetzen lässt. Insbesondere werden hier Oxide, Oxysulfate, oder Oxalate des Zirkoniums bzw. Hafniums, stärker bevorzugt die Oxide ZrO₂ bzw. HfO₂ eingesetzt. Dabei kann es auch hier bevorzugt sein, wenn Zirkonium und Hafnium in der "Quelle" schon in dem Verhältnis zueinander vorliegen, in dem diese Metallionen auch in der erfindungsgemäßen Verbindung der Formel I vorliegen sollen.

Unter einer Siliciumquelle versteht man erfindungsgemäß eine anorganische bzw. organische Siliciumquelle, wobei auch hier eine anorganische Siliciumquelle bevorzugt ist. Besonders bevorzugt wird hier Siliciumdioxid als Siliciumquelle eingesetzt.

Als Quelle eines der Metalle Samarium, Praseodym oder Europium können jegliche anorganische oder organische Verbindungen dieser Metalle eingesetzt werden, die diese Metalle in zwei- bzw. dreiwertiger Form enthalten und beim Kalzinieren in ein Oxid übergehen können. Eingesetzt werden können hier beispielsweise die Oxide, Oxalate, Acetate, Nitrate, Sulfate, oder Carbonate. Besonders bevorzugt sind Quellen dieser Metalle, bei denen die Metalle in dreiwertiger Form vorliegen. Insbesondere bevorzugt werden hier die Oxide des Samariums, Praseodyms oder Europiums, noch stärker bevorzugt Sm₂O₃, Pr₂O₃ und Eu₂O₃ eingesetzt.

Die bereitgestellten Quellen des Bariums bzw. Strontiums, des Zirkoniums bzw. Hafniums, des Siliciums und der Metalle Samarium, Praseodym oder Europium werden in Schritt b) intensiv miteinander vermengt. Die Vermengung wird vorzugsweise in einem Mörser durchgeführt, in dem zusätzlich vorzugsweise ein Vermahlungsmittel, wie beispielsweise Aceton hinzugegeben wird. Es ist weiterhin bevorzugt, dass während dem Schritt des Vermengens der oben genannten Quellen ein Borat-Salz (bspw. ein Alkaliborat wie Na₂B₄O₇) bzw. Borsäure als Sinterhilfe zugesetzt wird.

Nach dem Vermengen der Komponenten in Schritt b) wird das Pulver vorzugsweise in einem Temperaturbereich von 100 bis 300 °C getrocknet und anschließend einer Temperaturbehandlung im Bereich von 1000 bis 1700 °C, stärker bevorzugt 1200 bis 1600 °C unterzogen.

Wird eine Dotierung in der Verbindung der Formel I mit einem zweiwertigen Dotierion, vorzugsweise Eu²⁺, gewünscht (Referenz), so wird die Temperaturbehandlung vorzugsweise für 2 bis 4 h durchgeführt. Wird hierfür in Schritt a) des Verfahrens eine Quelle der Metalle Europium, Samarium oder Praseodym eingesetzt, bei der die Metalle in ihrer dreiwertigen Form vorliegen, so wird die Temperaturbehandlung vorzugsweise in einer reduzierenden Atmosphäre durchgeführt. Die reduktiven Bedingungen werden dabei z. B. mit Kohlenmonoxid, Formiergas, Wasserstoff oder zumindest Vakuum oder Sauerstoffmangel-Atmosphäre eingestellt, bevorzugt im Stickstoffstrom, vorzugsweise im N₂/H₂-Strom und insbesondere bevorzugt im N₂/H₂/NH₃-Strom. Es ist insbesondere bevorzugt, dass während der Temperaturbehandlung zunächst eine Atmosphäre enthaltend Kohlenmonoxid und anschließend eine Atmosphäre enthaltend Formiergas hergestellt wird. Wird eine Quelle der Metalle Europium, Samarium oder Praseodym eingesetzt, in der die Metalle in ihrer zweiwertigen Form vorliegen, so ist es nicht zwingend, dass die Temperaturbehandlung in einer reduzierenden Atmosphäre durchgeführt wird; es ist jedoch bevorzugt, dass unter Schutzgasatmosphäre (z. B. Ar, He, Ne oder N₂) gearbeitet wird.

Wird eine erfindungsgemäße Dotierung in der Verbindung der Formel I mit einem dreiwertigen Dotierion gewünscht, so wird die Temperaturbehandlung in Luft für vorzugsweise 2 bis 4 h durchgeführt.

Wie bereits oben erwähnt, enthalten die mit einem dreiwertigen Dotierion dotierten erfindungsgemäßen Verbindungen der Formel I zum Ladungsausgleich ein Alkalimetallion. Deshalb wird in dem erfindungsgemäßen Verfahren zur Herstellung von Verbindungen der Formel I, die ein dreiwertiges Dotierion enthalten, zusätzlich bei dem Schritt a) des Vermengens eine anorganische Alkalimetallverbindung, vorzugsweise ein Alkalimetallsalz wie Alkalicarbonat, Alkalisulfat oder Alkalichlorid, stärker bevorzugt Alkalicarbonat und am meisten bevorzugt Natriumcarbonat eingesetzt.

Die in Schritt a) des erfindungsgemäßen Verfahrens eingesetzten Quellen werden hinsichtlich des molaren Gehalts der Metalle in einem solchen Verhältnis zueinander eingewogen, dass das Molverhältnis dem gewünschten Verhältnis im Endprodukt (Verbindung der Formel I) entspricht.

Die Sinterhilfe wird vorzugsweise in einer Menge im Bereich von 0 bis 8 mol% bezogen auf die Gesamtmenge aller in Schritt a) des erfindungsgemäßen Verfahrens eingesetzten Quellen zugegeben.

Die Verbindung der Formel I wird durch das erfindungsgemäße Verfahren in Form von Partikeln erhalten, indem man den Sinterkuchen mit Mahlkugeln mahlt, siebt und anschließend klassifiziert. Die erfindungsgemäße Verbindung der Formel I liegt vorzugsweise in Form von Partikeln vor. Die Partikel weisen vorzugsweise eine Partikelgröße im Bereich von 50 nm bis 30 µm und stärker bevorzugt von 1 µm bis 20 µm auf. Die Partikel der Verbindung der Formel I können auch eine Oberfläche aufweisen, die funktionelle Gruppen trägt, die eine chemische Anbindung an umgebende Bindemittel aus beispielsweise Epoxy- oder Siliconharz und / oder Gläsern bzw. Kunststoffen, wie Acrylaten, Polycarbonaten ermöglicht. Diese funktionellen Gruppen können z. B. über Oxogruppen angebundene Ester oder andere Derivate sein, die mit Bestandteilen der Bindemittel Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Maß eingestellt werden. Damit kann die Verarbeitung der Gemische vereinfacht werden.

Ein weiterer Gegenstand der vorliegenden Erfindung ist die Verwendung der Verbindung der Formel I als Leuchtstoff, insbesondere als Konversionsleuchtstoff.

In der vorliegenden Anmeldung wird unter dem Begriff "Konversionsleuchtstoff" ein Material verstanden, das in einem bestimmten Wellenlängenbereich des elektromagnetischen Spektrums, vorzugsweise im blauen oder UV-Bereich, insbesondere im nahen UV-Bereich, Strahlung absorbiert und in einem anderen Wellenlängenbereich des elektromagnetischen Spektrums sichtbares Licht emittiert.

Ein weiterer Gegenstand der vorliegenden Erfindung ist ein Emissions-konvertierendes Material umfassend eine erfindungsgemäße Verbindung der Formel I. Das Emissions-konvertierende Material kann aus der Verbindung der Formel I bestehen und wäre in diesem Fall mit dem oben definierten Begriff "Konversionsleuchtstoff" gleichzusetzen.

Es ist jedoch bevorzugt, dass das erfindungsgemäße Emissions-konvertierende Material neben dem erfindungsgemäßen Konversionsleuchtstoff noch weitere Konversionsleuchtstoffe enthält. In diesem Fall enthält das erfindungsgemäße Emissions-konvertierende Material eine Mischung aus mindestens zwei Konversionsleuchtstoffen, wobei einer davon eine Verbindung der Formel I ist. Es ist insbesondere bevorzugt, dass die mindestens zwei Konversionsleuchtstoffe Leuchtstoffe sind, die Licht von Wellenlängen emittieren, die komplementär zueinander sind. Handelt es sich bei dem Konversionsleuchtstoff beispielsweise um einen cyan-emittierenden Leuchtstoff (zweiwertiges Eu), so wird dieser bevorzugt in Kombination mit einem orange-emittierenden Konversionsleuchtstoff eingesetzt. Alternativ dazu kann auch der cyan-emittierende Konversionsleuchtstoff in Kombination mit (einem) grün- und rot-emittierenden Konversionsleuchtstoff(en) eingesetzt werden. Handelt es sich bei dem erfindungsgemäßen Konversionsleuchtstoff um einen rot-emittierenden Leuchtstoff (dreiwertiges Dotiermittel), so wird dieser bevorzugt mit (einem) cyan- und grün-emittierenden Leuchtstoff(en) eingesetzt. Es ist also besonders bevorzugt, dass der erfindungsgemäße Konversionsleuchtstoff in Kombination mit einem oder mehreren weiteren Konversionsleuchtstoffen in dem erfindungsgemäßen Emissions-konvertierenden Material eingesetzt wird, die dann zusammen vorzugsweise weißes Licht emittieren.

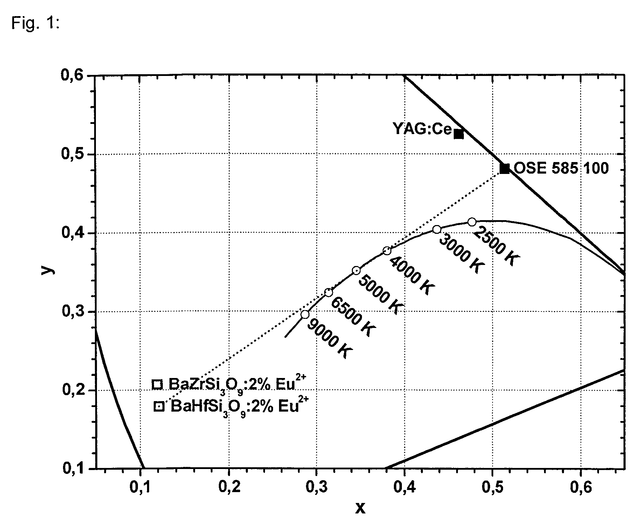

So kann beispielsweise ein cyan-emittierender Konversionsleuchtstoff in Kombination mit (Sr,Ca)₂SiO₄:Eu als weiterer Konversionsleuchtstoff eingesetzt werden. Figur 1 zeigt ein Farbdiagramm mit den Farbwerten von BaZrSi₃O₉:Eu²⁺ und BaHfSi₃O₉:Eu²⁺ sowie von (Sr,Ca)₂SiO₄:Eu als orangefarbener Emitter.

Die weiteren Konversionsleuchtstoffe werden vorzugsweise aus der Gruppe ausgewählt, die aus Sulfiden, Silicaten, Aluminaten, Boraten, Nitriden, Oxynitriden, Siliconitriden und Alumosiliconitriden besteht, die mit Eu²⁺, Ce³⁺ oder Mn²⁺ dotiert sind. In der folgenden Tabelle 1 sind diverse Beispiele solcher Leuchtstoffe aufgelistet.

**Tab. 1: Rot, orange, gelb, grün und cyan emittierende Leuchtstoffe, die in der Kombination mit den hier beanspruchten Leuchtstoffen Verwendung finden können.**

| **Zusammensetzung** | **Emissionsfarbe** | **λₘₐₓ [nm]** |
|---|---|---|
| LaAl(Si_{6-z}Al_{z})-(N_{10-z}O_{z}):Ce | Cyan | 460 - 500 |
| CaSi₂O_{2-z}N_{2+2/3z}:Eu | Grün | 534 - 562 |
| γ-AlON:Mn-Mg | Grün | 512 |
| (Ba₁₋ₓSrₓ)₂SiO₄:Eu | Grün | 520 - 560 |
| SrGa₂S₄:Eu | Grün | 535 |
| SrSi₂N₂O₂:Eu | Grün | 535 - 554 |
| SrAlSi₄N₇:Eu | Cyan und Rot | 500, 632 |
| Ba₂ZnS₃:Ce, Eu | Cyan und Rot | 498, 655 |
| LaSr₂AlO₅:Ce | Gelb | 556 |
| Tb₃Al₅O₁₂:Ce | Gelb | 545 - 555 |
| Sr₂Si₅N₈:Ce | Gelb | 553 |
| CaSi₂N₂O₂: Eu | Gelb | 565 |
| (Sr₁₋ₓCaₓ)₂SiO₄:Eu | Orange | 560 - 600 |
| MgS:Eu | Orange | 580 |
| Sr₃SiO₅:Eu | Orange | 570 |
| Ca₂BO₃Cl:Eu | Orange | 573 |
| Li-α-SiAlON:Eu | Orange | 573 |
| CaAlSiN₃:Ce | Orange | 580 |
| SrLi₂SiO₄:Eu | Orange | 562 |
| Ca₂SiS₄:Eu | Orange bis Rot | 550,660 |
| Y₃Mg₂AlSi₂O₁₂:Ce | Orange bis Rot | 600 |
| (Ca_{1-x-y}SrₓBa_{y})₂Si₅N₈:Eu | Orange bis Rot | 580 - 640 |
| (Ca₁₋ₓSrₓ)AlSiN₃:Eu | Rot | 630 - 650 |
| Lu₂CaMg₂Si₃O₁₂:Ce | Rot | 605 |
| Sr₃(Al₂O₅)Cl₂:Eu | Rot | 610 |
| Sr₂Si₅N₈:Eu | Rot | 625 |
| CaSiN₂:Ce | Rot | 625 |
| SrSiN₂:Eu | Rot | 670 - 685 |
| (Ca_{1-X}Srₓ)S:Eu | Rot | 610-655 |
| SrSiO₅:Ce, Li | Cyan bis Rot | 465 - 700 |
| Ca-α-SiAlON:Eu | Cyan bis Rot | 500 - 700 |
| MgSiN₂:Mn | Gelb bis Rot | 550 - 800 |

Im Kontext dieser Anmeldung wird als cyan-farbenes Licht solches Licht bezeichnet, dessen Intensitätsmaximum zwischen 460 und 505 nm Wellenlänge liegt, als grünes Licht solches Licht, dessen Intensitätsmaximum zwischen 505 und 545 nm Wellenlänge liegt, als gelbes Licht solches Licht, dessen Intensitätsmaximum zwischen 545 und 565 nm Wellenlänge liegt, als oranges Licht solches Licht, dessen Intensitätsmaximum zwischen 565 und 600 nm Wellenlänge liegt und als rotes Licht solches Licht, dessen Maximum zwischen 600 und 670 nm Wellenlänge liegt.

Wird ein erfindungsgemäßer Konversionsleuchtstoff mit mindestens einem weiteren Konversionsleuchtstoff vermischt, so beträgt das Verhältnis von erfindungsgemäßem Konversionsleuchtstoff zu dem weiteren Leuchtstoff bevorzugt 20:1 bis 1:20, besonders bevorzugt 10:1 bis 1:10 und insbesondere bevorzugt 5:1 bis 1:5, bezogen auf das Gesamtgewicht der Leuchtstoffe.

Ein weiterer Gegenstand der vorliegenden Erfindung ist die Verwendung des erfindungsgemäßen Emissions-konvertierenden Materials in einer Lichtquelle.

Ein weiterer Gegenstand der vorliegenden Erfindung ist eine Lichtquelle, die eine Primärlichtquelle und das erfindungsgemäße Emissions-konvertierende Material enthält.

Auch hier kann es insbesondere bevorzugt sein, dass das Emissions-konvertierende Material neben dem erfindungsgemäßen Konversionsleuchtstoff mindestens einen weiteren Konversionsleuchtstoff umfasst, so dass die Lichtquelle vorzugsweise weißes Licht oder Licht mit einem bestimmten Farbpunkt (Color-on-demand-Prinzip) emittiert.

Die erfindungsgemäße Lichtquelle ist in einer bevorzugten Ausführungsform eine pc-LED. Eine pc-LED enthält in der Regel eine Primärlichtquelle und ein Emissions-konvertierendes Material. Das erfindungsgemäße Emissions-konvertierende Material kann hierfür entweder in einem Harz dispergiert (z. B. Epoxy- oder Siliconharz) oder bei geeigneten Größenverhältnissen direkt auf der Primärlichtquelle oder aber von dieser, je nach Anwendung, entfernt angeordnet sein (letztere Anordnung schließt auch die "Remote Phosphor Technologie" mit ein). Die Vorteile der "Remote Phosphor Technologie" sind dem Fachmann bekannt und z. B. der folgenden Publikation zu entnehmen: Japanese Journ. of Appl. Phys., Vol. 44, No. 21 (2005), L649-L651.

Die Primärlichtquelle kann ein Halbleiterchip, eine lumineszente, auf ZnO, TCO (Transparent conducting oxide), ZnSe oder SiC basierende Anordnung, eine auf einer organischen lichtemittierenden Schicht basierende Anordnung (OLED) oder eine Plasma- oder Gasentladungsquelle sein, am stärksten bevorzugt ein Halbleiterchip. Dem Fachmann sind mögliche Formen von derartigen Lichtquellen bekannt.

Ist die Primärlichtquelle ein Halbleiterchip, so handelt es sich vorzugsweise um ein lumineszentes Indium-Aluminium-Gallium-Nitrid (InAlGaN), insbesondere der Formel lnᵢGaⱼAlₖN, wobei 0 ≤ i, 0 ≤ j, 0 ≤ k, und i+j+k=1 ist.

Wie bereits erwähnt, kann das erfindungsgemäße Emissions-konvertierende Material insbesondere zum Einsatz in Lichtquellen, insbesondere pc-LEDs, auch in beliebigen äußere Formen, wie sphärische Partikel, Plättchen sowie strukturierte Materialien und Keramiken überführt werden. Diese Formen werden unter dem Begriff "Formkörper" zusammengefasst. Folglich handelt es sich bei den Formkörpern um Emissions-konvertierende Formkörper.

Die Herstellung eines beispielsweise keramischen Emissions-konvertierenden Formkörpers enthaltend das Emissions-konvertierende Material erfolgt vorzugsweise analog nach dem in der DE 10349038 beschriebenen Verfahren. Dabei wird die erfindungsgemäße Verbindung der Formel I, gegebenenfalls mit einem weiteren Material, welches als Matrix dient, vorzugsweise isostatisch verpresst und in Form eines homogenen dünnen und nicht porösen Plättchens direkt auf die Oberfläche einer als Chip ausgeformten Primärlichtquelle aufgebracht. Dies hat den Vorteil, dass keine ortsabhängige Variation der Anregung und Emission des Konversionsleuchtstoffes stattfindet, wodurch die damit ausgerüstete LED einen homogenen und farbkonstanten Lichtkegel emittiert und über eine hohe Lichtleistung verfügt. Der keramische Emissions-konvertierende Formkörper kann, falls erforderlich, mit einer Wasserglaslösung auf dem Untergrund des Chips fixiert werden.

In einer bevorzugten Ausführung besitzt der keramische Emissions-konvertierende Formkörper auf der einem Halbleiterchip entgegengesetzten Seite eine strukturierte (z. B. pyramidale) Oberfläche. Somit kann möglichst viel Licht aus dem keramischen Emissions-konvertierenden Formkörper ausgekoppelt werden. Die strukturierte Oberfläche auf dem keramischen Emissions-konvertierenden Formkörper wird vorzugsweise dadurch hergestellt, indem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne keramische Emissions-konvertierende Formkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Es sind jedoch auch Ausführungsformen für das Aufbringen des erfindungsgemäßen Emissions-konvertierenden Materials auf einen Chip als Primärlichtquelle möglich, bei dem das Emissions-konvertierende Material in Silicon als Schicht aufgebracht wird. Dabei weist das Silicon eine Oberflächenspannung auf, so dass die Schicht des Emissions-konvertierenden Materials auf mikroskopischer Ebene nicht einheitlich bzw. die Dicke der Schicht nicht durchweg konstant ist. Dadurch wird jedoch die Wirksamkeit der die Konversionsleuchtstoffe enthaltenden Schicht nicht oder zumindest nicht wesentlich eingeschränkt.

Ein weiterer Erfindungsgegenstand ist eine Beleuchtungseinheit, insbesondere zur Hintergrundbeleuchtung von Anzeigevorrichtungen, die mindestens eine erfindungsgemäße Lichtquelle enthält. Solche Beleuchtungseinheiten werden hauptsächlich in Anzeigevorrichtungen, insbesondere Flüssigkristallanzeigevorrichtungen (LC Display), mit einer Hintergrundbeleuchtung, eingesetzt. Daher ist auch eine derartige Anzeigevorrichtung Gegenstand der vorliegenden Erfindung.

In der Erfindungsvariante erfolgt die optische Ankopplung zwischen dem Emissions-konvertierenden Material und der Primärlichtquelle (insbesondere Halbleiterchips) vorzugsweise durch eine lichtleitende Anordnung. Dadurch ist es möglich, dass an einem zentralen Ort die Primärlichtquelle installiert wird und diese mittels lichtleitender Vorrichtungen, wie beispielsweise lichtleitenden Fasern, an das Emissions-konvertierende Material optisch angekoppelt ist. Auf diese Weise lassen sich den Beleuchtungswünschen angepasste Leuchten lediglich bestehend aus einem oder mehreren unterschiedlichen Konversionsleuchtstoffen, die zu einem Leuchtschirm angeordnet sein können, und einem Lichtleiter, der an die Primärlichtquelle angekoppelt ist, realisieren. Auf diese Weise ist es möglich, eine starke Primärlichtquelle an einen für die elektrische Installation günstigen Ort zu platzieren und ohne weitere elektrische Verkabelung, nur durch Verlegen von Lichtleitern an beliebigen Orten, Leuchten aus Emissions-konvertierenden Materialien, die an die Lichtleiter gekoppelt sind, zu installieren.

Die folgenden Beispiele und Figuren sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und kommerziell erhältlich, oder können nach bekannten Methoden synthetisiert werden. Es versteht sich weiterhin von selbst, dass sich sowohl in der Beschreibung als auch in den Beispielen die zugegebenen Mengen der Komponenten in den Zusammensetzungen immerzu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

Auch ohne weitere Ausführungen wird davon ausgegangen, dass ein Fachmann die obige Beschreibung in weitestem Umfang nutzen kann. Die bevorzugten Ausführungsformen sind deswegen lediglich als beschreibende, keinesfalls als in irgendeiner Weise limitierende Offenbarung aufzufassen.

### Beschreibung der Figuren

- **Fig. 1:**: CIE 1931 Farbdiagramm mit den Farbwerten von BaZrSi₃O₉:Eu²⁺ und BaHfSi₃O₉:Eu²⁺ sowie von (Sr, Ca)₂SiO₄:Eu als orange-farbener Emitter.
- **Fig. 2:**: Röntgenpulverdiffraktogramme von BaZrSi₃O₉:Eu²⁺ mit 2 mol% bzw. 0,5 mol% Europiumdotierung im Vergleich zu undotiertem BaZrSi₃O₉ (gemessen mit Cu K_{α1} Strahlung).
- **Fig. 3:**: Emissionsspektren von BaZrSi₃O₉:Eu²⁺ (λₑₓ = 380 nm) mit 2 mol% bzw. 0,5 mol% Europiumdotierung.
- **Fig. 4:**: Röntgenpulverdiffraktogramme von BaHfSi₃O₉:Eu²⁺ mit 2 mol% bzw. 0,5 mol% Europiumdotierung im Vergleich zu undotiertem BaZrSi₃O₉ (gemessen mit Cu K_{α1} Strahlung).
- **Fig. 5:**: Emissionsspektrem von BaHfSi₃O₉:Eu²⁺ (λₑₓ = 380 nm) mit 2 mol% bzw. 0,5 mol% Europiumdotierung.
- **Fig. 6:**: Emissionsspektren von BaZrSi₃O₉:Sm³⁺,Na⁺ und BaHfSi₃O₉:Sm³⁺,Na⁺ (λₑₓ = 160 nm); jeweils mit 1 mol% Dotierung.
- **Fig. 7:**: Emissionsspektren von BaZrSi₃O₉:Eu³⁺,Na⁺ und BaHfSi₃O₉:Eu³⁺,Na⁺ (λₑₓ = 160 nm) ; jeweils mit 1 mol% Dotierung.
- **Fig. 8:**: Emissionsspektren von BaZrSi₃O₉:Pr³⁺,Na⁺ und BaHfSi₃O₉:Pr³⁺,Na⁺ (λₑₓ = 160 nm); jeweils mit 0,5 mol% Dotierung.

### Beispiele

### Beispiel 1 (Referenz): Herstellung von BaZrSi₃O₉: 0,5 mol% Eu²⁺

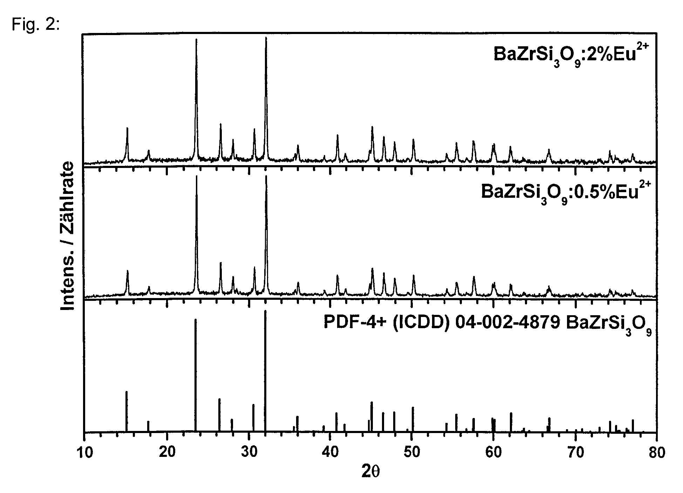

1,7191 g (8,71 mmol) BaCO₃, 1,0788 g (8,75 mmol) ZrO₂, 1,5781 g (26,26 mmol) SiO₂, 0,0077 g (0,022 mmol) Eu₂O₃ und 0,1200 g (1,94 mmol) H₃BO₃ werden gründlich in einem Achatmörser unter Zugabe einer geringen Menge Aceton als Vermahlungsmittel vermischt. Das Pulver wird bei 100 °C für 1 h getrocknet, in einen Aluminiumoxidtiegel überführt und bei einer Temperatur im Bereich von 1300 bis 1500 °C für 2 bis 4 h unter Kohlenmonoxidatmosphäre gesintert. In einem zweiten Sinterschritt in einem horizontalen Röhrenofen wurde das Pulver einer Temperatur von 1200 °C für 2 h unter einem Fluss von Formiergas (10 % H₂) unterzogen. Fig. 2 zeigt das Röntgenpulverdiffraktogramm der so hergestellten Verbindung.

### Beispiel 2 (Referenz): Herstellung von BaZrSi₃O₉: 2 mol% Eu²⁺

Diese Verbindung wird auf die gleiche Weise hergestellt wie die Verbindung in Beispiel 1, mit dem Unterschied, dass die folgenden Verbindungen zu Beginn eingewogen und dann vermischt werden: 1,6924 g (8,58 mmol) BaCO₃, 1,0783 g (8,75 mmol) ZrO₂, 1,5774 g (26,25 mmol) SiO₂, 0,0308 g (0,088 mmol) Eu₂O₃ und 0,1200 g (1,94 mmol) H₃BO₃. Das Röntgenpulverdiffraktogramm dieser Verbindung ist ebenso in Fig. 2 gezeigt.

Die Figur 3 zeigt die Emissionsspektren der in Beispiel 1 und Beispiel 2 hergestellten Verbindungen.

### Beispiel 3 (Referenz): Herstellung von BaHfSi₃O₉: 0,5 mol% Eu²⁺

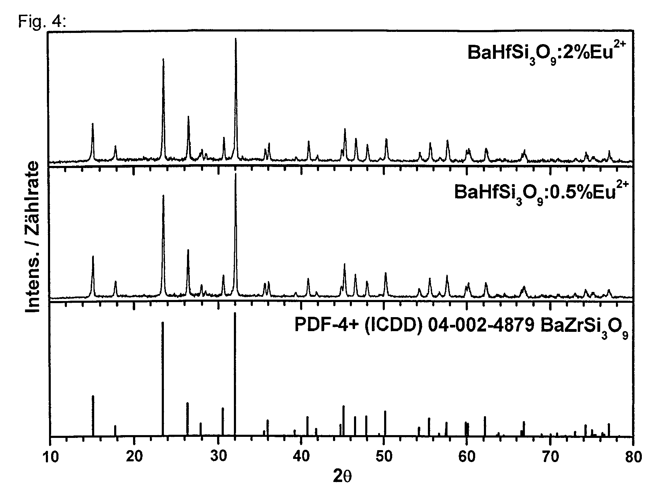

Diese Verbindung wird auf die gleiche Art und Weise hergestellt wie in Beispiel 1, mit dem Unterschied, dass die folgenden Bestandteile vermengt werden: 1,4434 g (7,31 mmol) BaCO₃, 1,5473 g (7,35 mmol) HfO₂, 1,3250 g (22,1 mmol) SiO₂, 0,0065 g (0,018 mmol) Eu₂O₃ und 1,1200 g (1,94 mmol) H₃BO₃. Das Röntgenpulverdiffraktogramm dieser Verbindung ist in Fig. 4 gezeigt.

### Beispiel 4 (Referenz): Herstellung von BaHfSi₃O₉: 2 mol% Eu²⁺

Diese Verbindung wird ebenso wie die Verbindung in Beispiel 1 hergestellt, mit dem Unterschied, dass die folgenden Bestandteile miteinander vermengt werden: 1,4211 g (7,20 mmol) BaCO₃, 1,5467 g (7,35 mmol) HfO₂, 1,3245 g (22,0 mmol) SiO₂, 0,0259 g (0,074 mmol) Eu₂O₃ und 0,1200 g (1,94 mmol) H₃BO₃. Das Röntgenpulverdiffraktogramm dieser Verbindung ist ebenso in Fig. 4 gezeigt.

Die Fig. 5 zeigt die Emissionsspektren der in den Beispielen 3 und 4 hergestellten Verbindungen.

### Beispiel 5: Herstellung von BaZrSi₃O₉: 1 mol% Sm³⁺, 1 mol% Na⁺

1,6972 g (8,60 mmol) BaCO₃, 1,0814 g (8,78 mmol) ZrO₂, 1,5819 g (26,33 mmol) SiO₂, 0,0153 g (0,044 mmol) Sm₂O₃, 0,0047 g (0,044 mmol) Na₂CO₃ und 0,1200 g (1,94 mmol) H₃BO₃ werden sorgfältig in einem Achatmörser unter Zugabe einer geringen Menge von Aceton als Vermahlungsmittel miteinander vermischt. Das Pulver wird 1 h bei 100 °C getrocknet, in einen Aluminiumoxidtiegel überführt und bei 1300 bis 1500 °C für 2 - 4 h in Luft gesintert.

### Beispiel 6: Herstellung von BaHfSi₃O₉: 1 mol% Sm³⁺, 1 mol% Na⁺

Diese Verbindung wird auf die gleiche Weise wie in Beispiel 5 hergestellt, mit dem Unterschied, dass die folgenden Ausgangsstoffe miteinander vermengt werden: 1,4245 g (7,22 mmol) BaCO₃, 1,5504 g (7,37 mmol) HfO₂, 1,3277 g (22,10 mmol) SiO₂, 0,0128 g (0,037 mmol) Sm₂O₃, 0,0039 g (0,037 mmol) Na₂CO₃ und 0,1200 g (1,94 mmol) H₃BO₃.

Die Fig. 6 zeigt die Emissionsspektren der in den Beispielen 5 und 6 hergestellten Verbindungen.

### Beispiel 7: Herstellung von BaZrSi₃O₉: 1 mol% Eu³⁺, 1 mol% Na⁺

Diese Verbindung wird ebenso hergestellt wie die Verbindung in Beispiel 5, mit dem Unterschied, dass folgende Ausgangsverbindungen miteinander vermengt werden: 1,6971 g (8,60 mmol) BaCO₃, 1,0814 g (8,78 mmol) ZrO₂, 1,5818 g (26,33 mmol) SiO₂, 0,0154 g (0,044 mmol) Eu₂O₃, 0,0047 g (0,044 mmol) Na₂CO₃ und 0,1200 g (1,94 mmol) H₃BO₃.

### Beispiel 8: Herstellung von BaHfSi₃O₉: 1 mol% Eu³⁺, 1 mol% Na⁺

Diese Verbindung wird auf die gleiche Weise hergestellt wie die Verbindung unter Beispiel 5, mit dem Unterschied, dass folgende Ausgangsverbindungen miteinander vermengt werden: 1,4244 g (7,22 mmol) BaCO₃, 1,5504 g (7,37 mmol) HfO₂, 1,3277 g (22,10 mmol) SiO₂, 0,0130 g (0,037 mmol) Eu₂O₃, 0,0039 g (0,037 mmol) Na₂CO₃ und 0,1200 g (1,94 mmol) H₃BO₃.

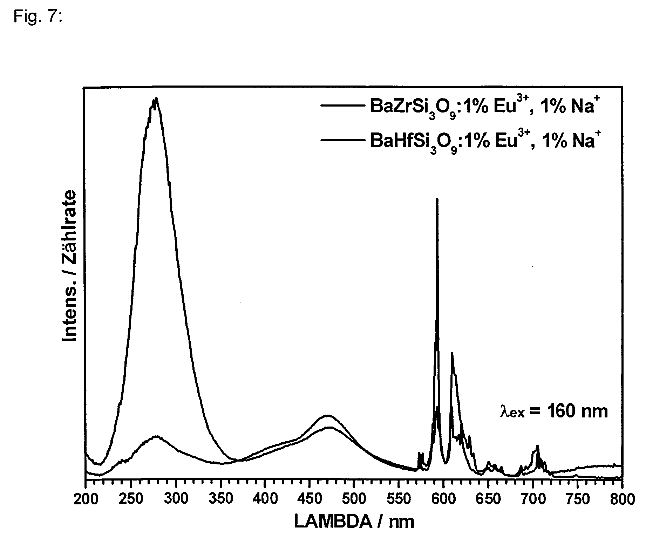

Die Fig. 7 zeigt die die Emissionsspektren der in den Beispielen 7 und 8 hergestellten Verbindungen.

### Beispiel 9: Herstellung von BaZrSi₃O₉: 0,5 mol% Pr³⁺, 0,5 mol% Na⁺

Diese Verbindung wird ebenso hergestellt wie die Verbindung in Beispiel 5, mit dem Unterschied, dass die folgenden Ausgangsverbindungen miteinander vermengt werden: 1,7128 g (8,68 mmol) BaCO₃, 1,0803 g (8,78 mmol) ZrO₂, 1,5803 g (26,30 mmol) SiO₂, 0,0159 g (0,022 mmol) Pr₂(C₂O₄)₃ · 10 H₂O, 0,0023 g (0,022 mmol) Na₂CO₃ und 0,1200 g (1,94 mmol) H₃BO₃.

### Beispiel 10: Herstellung von BaHfSi₃O₉: 0,5 mol% Pr³⁺, 0,5 mol% Na⁺

Diese Verbindung wird auf die gleiche Weise hergestellt wie die Verbindung in Beispiel 5, mit dem Unterschied, dass die folgenden Ausgangsverbindungen miteinander vermengt werden: 1,4378 g (7,29 mmol) BaCO₃, 1,5491 g (7,36 mmol) HfO₂, 1,3266 g (22,08 mmol) SiO₂, 0,0134 g (0,018 mmol) Pr₂(C₂O₄)₃ · 10 H₂O, 0,0020 g (0,018 mmol) Na₂CO₃ und 1,1200 g (1,94 mmol) H₃BO₃.

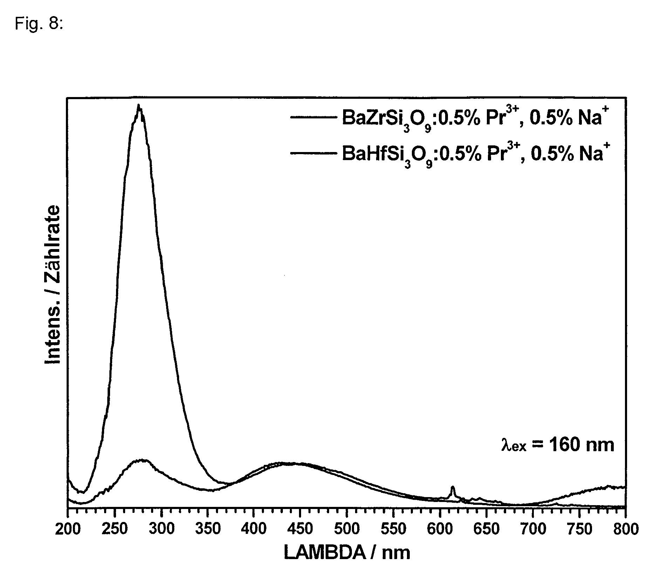

Die Fig. 8 zeigt die und die Emissionsspektren der in den Beispielen 9 und 10 hergestellten Verbindungen.

### Beispiel 11: Herstellung einer pc-LED unter Verwendung erfindungsgemäßer Verbindungen

1 g eines erfindungsgemäßen Leuchtstoffs aus Beispiel 1 bis 10 wird in einem Speedmixer mit 10 g eines optisch transparenten Silikons (OE 6550 der Fa. Dow Corning) dispergiert. Das so erhaltene Silikon-Leuchtstoff-Gemisch wird mit Hilfe eines automatischen Dispensers (CDS 6200 der Fa. Essemtech) auf den Chip einer blauen Halbleiter-LED (Unicorn package der Fa. Mimaki Electronics, ausgestattet mit einem bei 450 nm emittierenden InGaN-chip) aufgebracht und unter Wärmezufuhr in einem Wärmeschrank bei 150 °C innerhalb 1 h ausgehärtet.

### Beispiel 12: Testergebnisse der unter Beispiel 11 hergestellten pc-LEDs

Die LED aus Beispiel 11 wird mit einem Keithley Sourcemeter K2400 mit Strom kontaktiert (350 mA) und die optischen Eigenschaften werden mit einem Spektrometer Instruments Systems CAS 140, ausgestattet mit einer Integrationskugel, bestimmt. Aus dem hierbei erhaltenen Emissionsspektrum errechnet die Gerätesoftware des Spektrometers die LED Farbpunkte CIE 1931 x und y. In Figur 1 sind die entsprechenden Werte im CIE-Diagramm aufgetragen.

## Patentansprüche

1. Verbindung der Formel I
(Ba_{y}Sr_{1-y})Zr₁₋ₓHfₓSi₃O₉ (I),
wobei x im Bereich von 0 bis 1 liegt und unabhängig davon y im Bereich von 0 bis 1 liegt,
**dadurch gekennzeichnet, dass** ein Teil der Zr- bzw. Hf-Ionen durch dreiwertige Metallionen, die aus der Gruppe bestehend aus Pr³⁺, Sm³⁺, Eu³⁺ und Kombinationen davon ausgewählt sind, ersetzt ist und zum Ladungsausgleich eine zu den Pr³⁺-, Sm³⁺- und Eu³⁺-Ionen äquivalente Menge an Alkalimetallionen vorhanden ist.

2. Verbindung nach Anspruch 1, **dadurch gekennzeichnet, dass** 0,1 bis 20 mol%, vorzugsweise 0,2 bis 10 mol%, der Zr- bzw. Hf-Ionen durch Pr³⁺-, Sm³⁺- oder Eu³⁺-Ionen ersetzt ist.

3. Verbindung nach Anspruch 1 oder 2, **dadurch gekennzeichnet, dass** x gleich 0 oder 1 ist.

4. Verbindung nach einem oder mehreren der Ansprüche 1 bis 3, **dadurch gekennzeichnet, dass** gilt 0 ≤ y < 0,3, bevorzugt y = 0, oder dass gilt 0,7 < y ≤ 1, bevorzugt y = 1.

5. Verfahren zur Herstellung einer Verbindung gemäß einem oder mehreren der Ansprüche 1 bis 4, umfassend folgende Verfahrensschritte:
a) Bereitstellen einer Barium- und/oder Strontiumquelle, einer Zirkonium- bzw. Hafniumquelle, einer Siliciumquelle und einer Quelle eines der Metalle Samarium, Praseodym oder Europium;
b) Vermengen der unter Schritt a) bereitgestellten Quellen; und
c) Temperaturbehandlung der unter Schritt b) vermengten Quellen im Bereich von 1000 bis 1700 °C,
**dadurch gekennzeichnet, dass** in Schritt a) zusätzlich eine anorganische Alkalimetallverbindung bereitgestellt wird und die Temperaturbehandlung in Schritt c) an Luft durchgeführt wird.

6. Verwendung einer Verbindung nach einem oder mehreren der Ansprüche 1 bis 4 als Konversionsleuchtstoff.

7. Emissions-konvertierendes Material umfassend eine Verbindung nach einem oder mehreren der Ansprüche 1 bis 4.

8. Emissions-konvertierendes Material nach Anspruch 7, das zusätzlich mindestens einen weiteren Konversionsleuchtstoff enthält, wobei der weitere Konversionsleuchtstoff bevorzugt aus der Gruppe ausgewählt ist, die aus Sulfiden, Silicaten, Aluminaten, Boraten, Nitriden, Oxynitriden, Siliconitriden und Alumosiliconitriden besteht, die mit Eu²⁺, Ce³⁺ oder Mn²⁺ dotiert sind.

9. Lichtquelle, **dadurch gekennzeichnet, dass** sie eine Primärlichtquelle und ein Emissions-konvertierendes Material nach Anspruch 7 oder 8 umfasst.

10. Lichtquelle nach Anspruch 9, **dadurch gekennzeichnet, dass** es sich bei der Primärlichtquelle um ein lumineszentes Indium-Aluminium-Gallium-Nitrid handelt.

11. Beleuchtungseinheit, insbesondere zur Hintergrundbeleuchtung von Anzeigevorrichtungen, **dadurch gekennzeichnet, dass** sie mindestens eine Lichtquelle nach Anspruch 9 oder 10 enthält.

12. Anzeigevorrichtung, insbesondere Flüssigkristallanzeigevorrichtung (LC-Display), **dadurch gekennzeichnet, dass** sie mindestens eine Beleuchtungseinheit nach Anspruch 11 enthält.

## Claims

1. Compound of the formula I
(Ba_{y}S_{1-y})Zr₁₋ₓHfₓSi₃O₉ (I),
where x is in the range from 0 to 1 and, independently thereof, y is in the range from 0 to 1,
**characterised in that** some of the Zr or Hf ions have been replaced by trivalent metal ions selected from the group consisting of Pr³⁺, Sm³⁺, Eu³⁺ and combinations thereof, and an amount of alkali-metal ions equivalent to the Pr³⁺, Sm³⁺ and Eu³⁺ ions is present for charge compensation.

2. Compound according to Claim 1, **characterised in that** 0.1 to 20 mol%, preferably 0.2 to 10 mol%, of the Zr or Hf ions have been replaced by Pr³⁺, Sm³⁺ or Eu³⁺ ions.

3. Compound according to Claim 1 or 2, **characterised in that** x is equal to 0 or 1.

4. Compound according to one or more of Claims 1 to 3, **characterised in that** 0 ≤ y < 0.3, preferably y = 0, or **in that** 0.7 < y ≤ 1, preferably y = 1.

5. Process for the preparation of a compound according to one or more of Claims 1 to 4, comprising the following process steps:
a) provision of a barium and/or strontium source, a zirconium or hafnium source, a silicon source and a source of one of the metals samarium, praseodymium or europium;
b) mixing of the sources provided in step a); and
c) temperature treatment of the sources mixed in step b) in the range from 1000 to 1700°C,
**characterised in that** an inorganic alkali-metal compound is additionally provided in step a) and the temperature treatment in step c) is carried out in air.

6. Use of a compound according to one or more of Claims 1 to 4 as conversion phosphor.

7. Emission-converting material comprising a compound according to one or more of Claims 1 to 4.

8. Emission-converting material according to Claim 7, which additionally comprises at least one further conversion phosphor, where the further conversion phosphor is preferably selected from the group consisting of sulfides, silicates, aluminates, borates, nitrides, oxynitrides, silico-nitrides and alumosiliconitrides which are doped with Eu²⁺, Ce³⁺ or Mn²⁺.

9. Light source, **characterised in that** it contains a primary light source and an emission-converting material according to Claim 7 or 8.

10. Light source according to Claim 9, **characterised in that** the primary light source is a luminescent indium aluminium gallium nitride.

11. Lighting unit, in particular for the backlighting of display devices, **characterised in that** it contains at least one light source according to Claim 9 or 10.

12. Display device, in particular liquid-crystal display device (LC display), **characterised in that** it contains at least one lighting unit according to Claim 11.

## Revendications

1. Composé de la formule I :
(Ba_{y}Sr_{1-y})Zr₁₋ₓHfₓSi₃O₉ (I),
dans laquelle x est dans la plage de 0 à 1 et, indépendamment de celui-ci, y est dans la plage de 0 à 1,
**caractérisé en ce que** certains des ions Zr ou Hf ont été remplacés par des ions de métaux trivalents choisis parmi le groupe constitué par Pr³⁺, Sm³⁺, Eu³⁺ et des combinaisons afférentes, et une quantité d'ions de métaux alcalins équivalents aux ions Pr³⁺, Sm³⁺ et Eu³⁺ est présente pour une compensation de charges.

2. Composé selon la revendication 1, **caractérisé en ce que** 0,1 à 20 en % molaire, de façon préférable 0,2 à 10 en % molaire, des ions Zr ou Hf ont été remplacés par des ions Pr³⁺, Sm³⁺ ou Eu³⁺.

3. Composé selon la revendication 1 ou 2, **caractérisé en ce que** x est égal à 0 ou 1.

4. Composé selon une ou plusieurs des revendications 1 à 3, **caractérisé en ce que** 0 ≤ y < 0,3, de façon préférable y = 0, ou **en ce que** 0,7 < y ≤ 1, de façon préférable y = 1.

5. Procédé pour la préparation d'un composé selon une ou plusieurs des revendications 1 à 4, comprenant les étapes de procédé qui suivent :
a) fourniture d'une source de baryum et/ou de strontium, d'une source de zirconium ou d'hafnium, d'une source de silicium et d'une source de l'un des métaux que sont samarium, praséodyme ou europium ;
b) mélange des sources fournies au niveau de l'étape a) ; et
c) traitement en température des sources mélangées au niveau de l'étape b) dans la plage de 1000 à 1700°C,
**caractérisé en ce qu'**un composé de métal alcalin inorganique est fourni de façon additionnelle au niveau de l'étape a) et le traitement en température au niveau de l'étape c) est mis en oeuvre dans l'air.

6. Utilisation d'un composé selon une ou plusieurs des revendications 1 à 4 en tant que phosphore de conversion.

7. Matériau de conversion d'émission comprenant un composé selon une ou plusieurs des revendications 1 à 4.

8. Matériau de conversion d'émission selon la revendication 7, lequel comprend de façon additionnelle au moins un autre phosphore de conversion, où l'autre phosphore de conversion est de façon préférable choisi parmi le groupe constitué par les sulfures, les silicates, les aluminates, les borates, les nitrures, les oxynitrures, les silico-nitrures et les alumosiliconitrures qui sont dopés avec Eu²⁺, Ce³⁺ ou Mn²⁺.

9. Source de lumière, **caractérisée en ce qu'**elle contient une source de lumière primaire et un matériau de conversion d'émission selon la revendication 7 ou 8.

10. Source de lumière selon la revendication 9, **caractérisée en ce que** la source de lumière primaire est du nitrure d'indium aluminium gallium luminescent.

11. Unité d'éclairage, en particulier pour l'éclairage arrière des dispositifs d'affichage, **caractérisée en ce qu'**elle contient au moins une source de lumière selon la revendication 9 ou 10.

12. Dispositif d'affichage, en particulier dispositif d'affichage à cristaux liquides (affichage LC), **caractérisé en ce qu'**il contient au moins une unité d'éclairage selon la revendication 11.
